## Europäisches Patentamt
## European Patent Office
## Office européen des brevets

(11) Veröffentlichungsnummer: **0 178 497 B1**

(12) **EUROPÄISCHE PATENTSCHRIFT**

(45) Veröffentlichungstag der Patentschrift:
28.11.90

(51) Int. Cl.⁵: **H01S 3/06,** H01L 33/00, G02B 6/42

(21) Anmeldenummer: **85112053.5**

(22) Anmeldetag: **24.09.85**

(54) Verfahren zur integrierten Herstellung eines DFB-Lasers mit angekoppeltem Streifenwellenleiter auf einem Substrat.

(30) Priorität: **03.10.84 DE 3436306**

(43) Veröffentlichungstag der Anmeldung:
**23.04.86 Patentblatt 86/17**

(45) Bekanntmachung des Hinweises auf die Patenterteilung:
**28.11.90 Patentblatt 90/48**

(84) Benannte Vertragsstaaten:
**DE FR GB NL SE**

(56) Entgegenhaltungen:
GB-A- 1 539 028
US-A- 4 309 667

OPTICAL ENGINEERING, Band 19, Nr. 4, Juli/August 1980, Seiten 581-586, Society of Photo-Optical Instrumentation Engineers; J.L. MERZ: "Heterostructure devices for integrated optics"
IEEE JOURNAL OF QUANTUM ELECTRONICS, Band QE-13, Nr. 4, April 1977, Seiten 220-223, New York, US; K. AIKI et al.: "A frequency-multiplexing light source with monolithically integrated distributed-feedback diode lasers"

(73) Patentinhaber: Siemens Aktiengesellschaft, Wittelsbacherplatz 2, D-8000 München 2(DE)

(72) Erfinder: Amann, Markus-Christian, Dr.-Ing., Unterhachingerstrasse 89, D-8000 München 83(DE)
Erfinder: Mahlein, Hans F., Dr. rer. nat., Queristrasse 2, D-8025 Unterhaching(DE)
Erfinder: Stegmüller, Bernhard, Dipl.-Ing., Seefelderstrasse 8, D-8900 Augsburg(DE)
Erfinder: Thulke, Wolfgang, Dr. rer. nat., Neubiberger Strasse 38, D-8000 München 83(DE)
Erfinder: Winzer, Gerhard, Dr.-Ing., Zugspitzstrasse 10, D-8011 Putzbrunn(DE)
Erfinder: Wolff, Ulrich, Dipl.-Phys., Geigenbergerstrasse 35, D-8000 München 71(DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft ein Verfahren gemäß dem Oberbegriff des Patentanspruchs 1.

Ein Verfahren der genannten Art ist aus IEEE Journal of Quan. Electronics, Vol. QE-13, No. 4, April 1977, S. 220-223 bekannt. Bei diesem Verfahren werden im ersten Epitaxieschritt sukzessive eine die tieferliegende Schicht bildende $n\text{-}Ga_{1-x}Al_x$-As-Schicht, beispielsweise mit $x = 0,3$ und einer Dicke von 2 µm, eine laseraktive Schicht aus p-GaAs, beispielsweise mit einer Dicke von 0,2 µm, eine $p\text{-}Ga_{1-y}Al_yAs$-Schicht, beispielsweise mit $y = 0,2$ und einer Dicke von 0,1 µm und eine die oberste Schicht bildende $PGa_{1-z}Al_zAs$-Schicht, beispielsweise mit $z = 0,07$ und einer Dicke von 0,2 µm mittels konventioneller Flüssigphasenepitaxie auf ein nGaAs-Substrat aufgewachsen. In die oberste Schicht dieses Schichtenstapels wird ein Gitter 3. Ordnung durch chemisches Ätzen mit Hilfe einer Maske erzeugt, die durch holografische Fotolithografie erzeugt worden ist. Der Schichtenstapel wird dann unter Ausnahme des Bereichs, der für den DFB-Lasers vorgesehen ist, bis zum Substrat chemisch abgeätzt. Dadurch entsteht eine den Bereich des aktiven Lasers von dem Bereich des passiven Streifenwellenleiters trennende Stufe, die bis in das Substrat hineinreicht.

Auf die gestufte Oberfläche werden im zweiten Epitaxieschritt zwei weitere Schichten - eine $pGa_{1-x}Al_xAs$-Schicht, beispielsweise mit $x = 0,3$ und einer Dicke von 2 µm und dann eine undotierte $Ga_{1-w}Al_wAs$-Schicht, beispielsweise mit $w = 0,1$ und einer Dicke von 2 µm - durch Flüssigphasenepitaxie unter relativ schnellen Wachstumsbedinungen aufgewachsen. Die von den beiden weiteren Schichten zuerst aufgewachsene $p\text{-}Ga_{1-x}Al_xAs$-Schicht wird innerhalb einer Dauer von 90 s bei 700°C mit einer Kühlrate von 5°C/min aufgewachsen. Unter diesen Bedingungen spaltet sich diese $p\text{-}Ga_{1-x}Al_xAs$-Schicht an der Stufe auf und die Laserausgangsleistung wird effektiv zur undotierten $Ga_{1-w}Al_wAs$-Schicht, welche den passiven Streifenwellenleiter bildet, geführt.

Die längsseitigen Begrenzungen des Lasers und des passiven Streifenwellenleiters werden durch Abätzen des Kristalls bis auf das Substrat erzeugt.

Bei dem durch dieses Verfahren hergestellten DFB-Laser mit angekoppeltem passivem Streifenwellenleiter erfolgt die Kopplung zwischen dem Laser und dem Streifenwellenleiter durch eine Stirnflächenkopplung.

Wie aus den Figuren 2 und 3 auf der Seite 221 der obengenannten Druckschrift zu erkennen ist, ist die Lage der Aufspaltung der von den beiden weiteren Schichten zuerst aufgewachsenen Schicht kritisch, weil sie möglichst genau am Ort der laseraktiven Schicht entstehen muß und ihre Lage nur über die Wachstumsbedingungen beim epitaktischen Aufwachsen gesteuert werden kann.

Aufgabe der vorliegenden Erfindung ist es, ein Verfahren der eingangs genannten Art anzugeben, mit dem DFB-Laser mit angekoppeltem passivem Streifenwellenleiter auf einem Substrat reproduzierbar und dadurch mit hoher Ausbeute hergestellt werden können.

Diese Aufgabe wird durch die im kennzeichnenden Teil des Patentanspruchs 1 angegebenen Merkmale gelöst.

Bei dem erfindungsgemäßen Verfahren wird von der Erzeugung einer Stirnflächenkopplung zwischen Laser und passivem Wellenleiter abgesehen und anstelle dessen wird auf eine Oberflächenkopplung zwischen dem Laser und dem angekoppelten passiven Streifenwellenleiter aufgebaut, d.h. auf eine Kopplung, bei der die Strahlung nicht zwischen den einander zugekehrten Stirnflächen der laseraktiven Schicht und des schichtförmigen Streifenwellenleiters, sondern seitlich über die einander gegenüberliegenden Oberflächen der laseraktiven Schicht und des schichtförmigen Streifenwellenleiters überkoppelt. Dadurch wird die Erzeugung einer aufgespaltenen Schicht überflüssig, so daß die damit verbundenen Schwierigkeiten beseitigt sind. Anstelle dessen muß des Abtragen des Schichtenstapels an einer definierten Stelle angehalten werden. Dies ist aber weniger kritisch, weil dadurch nur die Dicke der für den Streifenwellenleiter vorgesehenen tieferliegenden Schicht beeinträchtigt werden kann. Diese Dicke ist relativ unkritisch, und die zum Abtragen geeigneten Ätzvorgänge können relativ genau gesteuert werden.

Es liegt jedoch ein besonderer Vorteil des erfindungsgemäßen Verfahrens darin, daß das Abtragen des Schichtenstapels bis zur definierten Tiefe ohne großen Aufwand sehr genau, praktisch selbstjustierend, eingehalten werden kann, wenn nach Maßgabe des Anspruchs 2 vorgegangen wird.

Weitere bevorzugte und vorteilhafte Ausgestaltungen des erfindungsgemäßen Verfahrens gehen aus den übrigen Unteransprüchen hervor.

Die Erfindung wird beispielhaft anhand der Figuren in der folgenden Beschreibung näher erläutert. Von den Figuren zeigen:

Figur 1 einen in der vorgesehenen Längsrichtung des passiven Streifenwellenleiters geführten Schnitt durch ein Substrat mit im ersten Epitaxieschritt aufgebrachten Schichtstapel, in dessen oberste Schicht ein Gitter eingebracht ist;

Figur 2 die Anordnung nach Figur 1, wobei bereits die Stufe in den Schichtstapel eingebracht ist;

Figur 3 die Anordnung nach Figur 2 nach dem zweiten Epitaxieschritt, bei dem die beiden weiteren Schichten aufgebracht werden;

Figur 4 einen Querschnitt durch die Anordnung nach Figur 3 längs der Schnittlinie III - III.

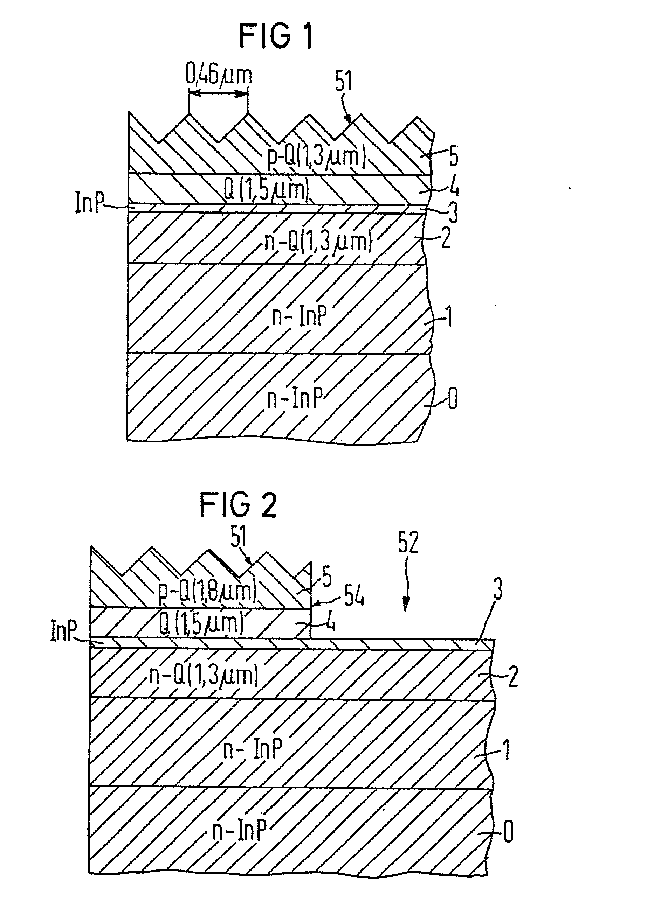

Die Anordnung nach Figur 1 wird so erzeugt, daß auf das Substrat 0, beispielsweise ein n-InP-Substrat, nacheinander eine Pufferschicht 1, beispielsweise eine n-InP-Schicht, die tieferliegende Schicht 2, beispielsweise eine n-Q-Schicht von beispielsweise 0,3 µm Dicke und einem einer Fluoreszenzwellenlänge von 1,3 µm entsprechenden Bandabstand, dann eine relativ dünne Ätzstoppschicht 3, beispielsweise eine InP-Schicht von 0,1 µm Dicke, dann die laseraktive Schicht 4, beispielsweise eine Q-Schicht von 0,2 µm Dicke und einem 1,5 µm entsprechenden Bandabstand und schließlich die oberste Schicht 5, beispielsweise eine p-Q-Schicht von

0,3 µm Dicke und einem wieder 1,3 µm entsprechenden Bandabstand, beispielsweise durch Flüssigphasenepitaxie aufgebracht werden. Diese Schichten können unmittelbar hintereinander und ohne Unterbrechung epitaktisch, d.h. in einem einzigen Epitaxieschritt, erzeugt werden.

Unter einer Q-Schicht ist eine quaternäre Schicht zu verstehen, d.h. eine Schicht aus einer quaternären Verbindung. Ein generelles Beispiel für eine solche Verbindung ist InGaAsP, wobei Indizes außer acht gelassen sind.

In die oberste Schicht 5 wird ganzflächig ein Gitter 51 eingeätzt, beispielsweise mit einer Gitterkonstanten von 0,46 µm. Die Rillen dieses Gitters 51 verlaufen senkrecht zur Längsrichtung des Streifenwellenleiters, also senkrecht zur Zeichenebene.

Die oberste Schicht 5 und die laseraktive Schicht werden in einem rechten Bereich 52 des Substrats bis auf die Ätzstoppschicht 3 herunter abgeätzt, wodurch die Stufe 54 entsteht (Figur 2).

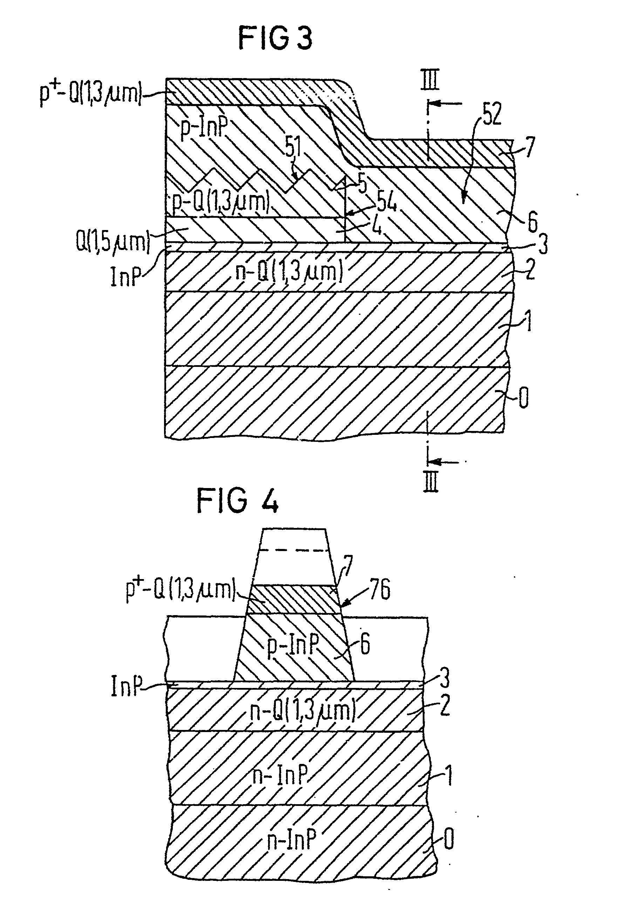

In einem zweiten Epitaxieschritt werden auf die gestufte Oberfläche die Schicht 7, beispielsweise eine p-InP- Schicht von beispielsweise 1,5 µm Dicke und die Schicht 6, beispielsweise eine p+-Q-Schicht von beispielsweise 0,3 µm Dicke ganzflächig aufgebracht (Figur 3).

Durch selektives Ätzen werden die Schichten 6 und 7 bis auf einen quer über die Stufe 51 verlaufenden Streifen 76 (Figur 4) abgeätzt, der sowohl das Gitter 51 als auch die verbliebene tieferliegende Schicht 2 bedeckt. Dieser Streifen definiert die längsseitigen Grenzen sowohl des im Bereich der laseraktiven Schicht 4 und des Gitters 51 liegenden Lasers als auch des passiven Streifenwellenleiters. Die Strahlung wird im wesentlichen unter diesem Streifen 76 geführt, und zwar sowohl in der laseraktiven Schicht als auch in der tieferliegenden Schicht 2, die zusammen mit dem Streifen 76 den passiven Streifenwellenleiter definiert. Die von unten an die Schicht 2 grenzende Pufferschicht 1 und die über der Schicht 2 liegende weitere Schicht 6 müssen zusammen mit der Ätzstoppschicht 3 einen kleineren Brechungsindex haben als die Schicht 2, damit diese als Wellenleiter wirken kann. Bei den oben angegebenen beispielhaft ausgewählten Materialien ist diese Forderung gewährleistet.

Die weitere Schicht 7 muß letztlich nur über dem Bereich des Lasers, also über der laseraktiven Schicht 4 und dem Gitter 51 vorhanden sein. Sie kann daher außerhalb dieses Bereichs entfernt werden. Auf ihr wird eine zum Betrieb des Lasers erforderliche Metallschicht als Kontakt aufgebracht.

Als weitere Vorteile der Erfindung sind zu nennen: Man kommt mit einer Zweiphasenepitaxie aus und die Herstellung eines einzigen Streifens für die seitliche Begrenzung sowohl des Lasers als auch des Streifenwellenleiters gewährleistet, daß der Laser und der Wellenleiter exakt miteinander fluchten.

## Patentansprüche

1. Verfahren zur integrierten Herstellung mindestens eines DFB-Lasers mit angekoppeltem passivem Streifenwellenleiter auf einem Substrat (0), wobei in einem ersten Epitaxieschritt ein Schichtenstapel auf dem Substrat (0) erzeugt wird, der eine zwischen der obersten Schicht (5) und einer tieferliegenden Schicht (2) des Schichtenstapels angeordnete laseraktive Schicht (4) enthält, die eine größere Brechzahl hat als die oberste (5) und die tieferliegende Schicht (2), wobei auf der obersten Schicht (5) dieses Schichtenstapels ein Gitter (51) erzeugt wird, wobei durch bereichsweises Abtragen des Schichtenstapels eine Stufe (54) in dem Stapel erzeugt wird, wobei in einem zweiten Epitaxieschritt auf die gestufte Oberfläche zwei weitere Schichten (6, 7) aufgebracht werden, von denen die zuerst aufgebrachte Schicht (6), die sowohl das Gitter (51) auf der obersten Schicht (5) des verbliebenen Schichtenstapels als auch den davon durch die Stufe (54) getrennten und von der laseraktiven Schicht (4) befreiten abgetragenen Bereich (52) bedeckt, eine niedrigere Brechzahl hat als die oberste Schicht (5) des Schichtenstapels, und wobei in einem Verfahrensschritt ein Streifen (76) erzeugt wird, der die längsseitigen Begrenzungen sowohl des Lasers als auch des angekoppelten passiven Streifenwellenleiters definiert, **dadurch gekennzeichnet,** daß das bereichsweise Abtragen des Schichtenstapels zur Erzeugung der Stufe (54) bis höchstens zu der tieferliegenden Schicht (2) des Schichtenstapels erfolgt, so daß diese tieferliegende Schicht (2), deren Brechzahl größer als die Brechzahl der im zweiten Epitaxieschritt von den beiden weiteren Schichten (6, 7) zuerst aufgebrachten Schicht (6) und größer als die Brechzahl des von unten her angrenzenden Mediums (1) gewählt ist, die die Dicke eines Schichtwellenleiters aufweist und die so nahe bei der laseraktiven Schicht (4) angeordnet ist, daß zwischen dieser (4) und der tieferliegenden Schicht (2) eine Oberflächenkopplung gegeben ist, ganz oder teilweise in ihrer Eigenschaft als Schichtwellenleiter erhalten bleibt, und daß nach dem zweiten Epitaxieschritt aus den dabei erzeugten beiden weiteren Schichten (6, 7) durch Abtrag der quer über die Stufe (54) verlaufende Streifen (76) erzeugt wird, der sowohl das Gitter (51) als auch die verbliebene tieferliegende Schicht (2) bedeckt.

2. Verfahren nach Anspruch 1, **dadurch gekennzeichnet,** daß das Abtragen des Schichtenstapels zur Erzeugung der Stufe durch Abätzen vorgenommen wird und daß beim ersten Epitaxieschritt eine relativ dünne Ätzstoppschicht (3) erzeugt wird, die zwischen der tieferliegenden Schicht (2) und der darüber angeordneten laseraktiven Schicht (4) angeordnet ist und die beim Erzeugen der Stufe den Ätzvorgang stoppt.

3. Verfahren nach Anspruch 1 oder 2, **dadurch gekennzeichnet,** daß das Gitter (51) ganzflächig auf die oberste Schicht (5) des Schichtenstapels aufgebracht wird.

4. Verfahren nach einem der vorhergehenden Ansprüche, **dadurch gekennzeichnet,** daß beim ersten Epitaxieschritt eine Pufferschicht (1) erzeugt wird, die zwischen dem Substrat (0) und der tieferliegenden Schicht (2) des Schichtenstapels angeordnet ist und an diese tieferliegende Schicht (2) angrenzt.

5. Verfahren nach einem der vorhergehenden Ansprüche, **dadurch gekennzeichnet, daß** der Streifen (76) durch selektives Ätzen erzeugt wird.

6. Verfahren nach einem der vorhergehenden Ansprüche, **dadurch gekennzeichnet, daß** die laseraktive Schicht (4), die tieferliegende Schicht (2) und die oberste Schicht (5) des Schichtenstapels aus quaternären Schichten bestehen.

7. Verfahren nach einem der vorhergehenden Ansprüche, **dadurch gekennzeichnet, daß** das Substrat (0) und gegebenenfalls die Pufferschicht (1) sowie die Ätzstoppschicht (3) zwischen der laseraktiven Schicht (4) und der tieferliegenden Schicht (5) und die im zweiten Epitaxieschritt von den beiden weiteren Schichten (6, 7) zuerst aufgebrachte Schicht (6) aus InP bestehen.

8. Verfahren nach einem der vorhergehenden Ansprüche, insbesondere nach Anspruch 6 und 7, **dadurch gekennzeichnet,** daß die im zweiten Epitaxieschritt als zweites aufgebrachte weitere Schicht (7) aus einer quaternären Schicht besteht.

## Claims

1. Method for producing in an integrated form at least one DFB laser having a coupled passive strip waveguide on a substrate (0), therhe being produced on the substrate (0), in a first epitaxial step, a stack of layers which contains a laser-active layer (4) which is disposed between the uppermost layer (5) and a deeper-lying layer (2) of the stack of layers and has a greater refractive index than the uppermost layer (5) and the lower-lying layer (2), a grating (51) being produced on the uppermost layer (5) of said stack of layers, a step (54) being produced in the stack by selectively removing the stack of layers, there being deposited on the stepped surface, in a second epitaxial step, two further layers (6, 7) of which the layer (6) which is deposited first and which covers both the grating (51) on the uppermost layer (5) of the residual stack of layers and also the region (52) removed which is separated therefrom by the step (54) and is freed from the laser-active layer (4) has a lower refractive index than the uppermost layer (5) of the stack of layers and, there being produced, in a process step, a strip (76) which defines the limits on the long side both of the laser and also of the coupled passive strip waveguide, characterized in that the selective removal of the stack of layers to produce the step (54) is carried out no further than the deeper lying layer (2) of the stack of layers so that said deeper-lying layer (2), whose refractive index is chosen to be greater than the refractive index of the layer (6) deposited as the first of the two further layers (6, 7) in the second epitaxial step and to be greater than the refractive index of the adjacent medium (1) underneath, which has the thickness of a layer waveguide and which is disposed close enough to the laser-active layer (4) for a surface coupling to exist between this layer (4) and the deeper-lying layer (2), remains completely or partly maintained in its property as a layer waveguides, and in that the strip (76) which extends transversely across the step (54) and which covers both the grating (51) and also the residual deeper-lying layer (2) is produced by removal after the second epitaxial layer from the two further layers (6, 7) produced in the latter process.

2. Method according to Claim 1, characterized in that the removal of the stack of layers to produce the step is carried out by etching and in.that, in the first epitaxial layer, a relatively thin etch-stop layer (3) is produced which is disposed between the deeper-lying layer (2) and the laser-active layer (4) disposed above it and which stops the etching process during the production of the step.

3. Method according to Claim 1 or 2, characterized in that the grating (51) is deposited over the entire area on the uppermost layer (5) of the stack of layers.

4. Method according to one of the preceding claims, characterized in that, in the first epitaxial step, a buffer layer (1) is produced which is disposed between the substrate (0) and the deeper-lying layer (2) of the stack of layers and adjoins said deeper-lying layer (2).

5. Method according to one of the preceding claims, characterized in that the strip (76) is produced by selective etching.

6. Method according to one of the preceding claims, characterized in that the laser-active layer (4), the deeper-lying layer (2) and the upper most layer (5) of the stack of layers are composed of quaternary layers.

7. Method according to one of the preceding claims, characterized in that the substrate (0) and optionally the buffer layer (1), and also the etch-stop layer (3) between the laser-active layer (4) and the deeper-lying layer (5) and the layer (6) deposited as the first of the two further layers (6, 7) in the second epitaxial step are composed in InP.

8. Method according to one of the preceding claims, in particular according to Claim 6 and 7, characterized in that the further layer (7) deposited second in the second epitaxial step is composed of a quaternary layer.

## Revendications

1. Procédé de fabrication intégrée d'au moins un laser DFB couplé à un guide d'ondes passif en forme de bande sur un substrat (0), selon lequel, lors d'une première étape d'épitaxie, on forme sur le substrat (0) une pile de couches, qui contient une couche (4) active pour la production de l'effet laser, qui est disposée entre la couche supérieure (5) et une couche inférieure (2) et qui possède un indice de réfraction supérieur à celui de la couche supérieure (5) et de la couche inférieure (2), et selon lequel on forme un réseau (51) sur la couche supérieure (5) de cette pile de couches, et selon lequel on forme une partie étagée (54) dans la pile, au moyen de l'enlèvement, par zones, de la pile de couches,

et selon lequel, lors d'une seconde étape d'épitaxie, on dépose sur la surface étagée deux couches suplémentaires (6, 7), parmi lesquelles la couche (6) déposée en premier lieu, qui recouvre aussi bien le réseau (51) situé sur la couche supérieure (5) de la pile restante de couches que la zone dégagée (52), séparée de la pile par la partie étagée (54) et dont a été retirée la couche (4) active pour l'effet laser, possède un indice de réfraction inférieur à celui de la couche supérieure (5) de la pile de couches, et

selon lequel lors d'une étape opératoire, on forme une bande (76) qui définit les limites longitudinales aussi bien du laser que du guide d'ondes couplé passif en forme de bande, caractérisé par le fait

que l'enlèvement par zones de la pile de couches servant à produire la partie étagée (54) s'effectue au maximum jusqu'à la couche inférieure (2) de la pile de couches, de sorte que cette couche inférieure (2)

dont l'indice de réfraction est choisi supérieur à l'indice de réfraction de la couche (6) déposée en premier lieu, parmi les deux autres couches (6, 7), lors de la seconde étape d'épitaxie, et est supérieur à l'indice de réfraction du milieu sous-jacent contigu (2), qui possède l'épaisseur d'un guide d'ondes en forme de couche et est disposé à proximité suffisante de la couche (4) active du point de vue de l'effet laser, pour qu'il existe un couplage superficiel entre cette couche (4) et la couche inférieure (2),

conserve en totalité ou en partie sa caractéristique de guide d'ondes de couche, et

qu'après la seconde étape d'épitaxie, on forme, par enlèvement, à partir des deux autres couches (6, 7) alors formées, de la bande (76), qui s'étend transversalement au-dessus de la partie étagée (54) et recouvre aussi bien le réseau (51) que la couche inférieure subsistante (2).

2. Procédé suivant la revendication 1, caractérisyé par le fait que l'élimination de la pile de couches pour la formation de la partie étagée est exécutée au moyen d'une corrosion et que, lors de la première étape d'épitaxie, on forme une couche relativement mince d'arrêt de corrosion (3), qui est disposée entre la couche inférieure (2) et la couche (4) active pour l'effet laser, située au-dessus de la couche précédente et qui arrête l'opération de corrosion lors de la formation de la partie étagée.

3. Procédé suivant la revendication 1 ou 2, caractérisé par le fait qu'on dépose le réseau (51) sur toute la surface de la couche supérieure (5) de la pile de couches.

4. Procédé suivant l'une des revendications précédentes, caractérisé par le fait que, lors de la première étape d'épitaxie, on forme une couche tampon (1), qui est disposée entre le substrat (0) et la couche inférieure (2) de la pile de couches et jouxte cette couche inférieure (2).

5. Procédé suivant l'une des revendications précédentes, caractérisé par le fait que la bande (76) est formée par corrosion sélective.

6. Procédé suivant l'une des revendications précédentes, caractérisé par le fait que la couche (4) active pour l'effet laser, la couche inférieure (2) et la couche supérieure (5) de la pile sont constituées par des couches quaternaires.

7. Procédé suivant l'une des revendications précédentes, caractérisé par le fait que le substrat (0) et éventuellement la couche tampon (1) ainsi que la couche (3) d'arrêt de la corrosion entre la couche (4) active pour l'effet laser et la couche inférieure (5), et la couche (6) déposée la première parmi les deux autres couches (6, 7) lors de la seconde étape d'épitaxie, sont constituées par du InP.

8. Procédé suivant l'une des revendications précédentes et notamment suivant la revendication 6 et 7, caractérisé par le fait que l'autre couche (7), déposée en tant que seconde couche lors de la seconde étape d'épitaxie, est constituée par une couche quaternaire.

## FIG 1

## FIG 2

# FIG 3

$p^+$-Q(1,3 μm)

p-InP

51

5

p-Q(1,3 μm)

54

4

Q(1,5 μm)

InP

n-Q(1,3 μm)

52

7

6

3

2

1

0

III

III

# FIG 4

$p^+$-Q(1,3 μm)

7

76

p-InP

6

InP

3

n-Q(1,3 μm)

2

n-InP

1

n-InP

0